# EUROPEAN PATENT APPLICATION

(11) **EP 3 299 484 A1**
(43) Date of publication of application: **28.03.2018**
(21) Application number: 16810730.8
(22) Date of filing: 28.01.2016
(51) Int. Cl.: C22C 23/00, C22C 23/02, C22C 23/06, H04B 1/38, H04M 1/02, H05K 1/02, H05K 7/20

(54) **COMMUNICATION DEVICE**

(30) Priority: 18.06.2015 CN 201510340994
(71) Applicant: Huawei Technologies Co., Ltd., Longgang District Shenzhen, Guangdong 518129 (CN)
(72) Inventor: FU, Liang, Shenzhen, Guangdong 518129 (CN); XIAO, Chunxiu, Shenzhen, Guangdong 518129 (CN); HU, Banghong, Shenzhen, Guangdong 518129 (CN)
(74) Representative: Pfenning, Meinig & Partner mbB
(86) International application number: PCT/CN2016/072499
(87) International publication number: WO 2016/201989

(57) **Abstract**

A communications device is provided, including an electronic part and a magnesium alloy housing. Constituents in a magnesium alloy material used in the magnesium alloy housing are configured according to the following mass percentages: aluminum: less than 10%; rare-earth element: 1% to 10%; manganese: less than 1%; zinc: less than 1%; zirconium: less than 1%; and calcium: less than 3%; and the rest is magnesium and an unavoidable impurity.

## Description

This application claims priority to Chinese Patent Application No. 201510340994.6, filed with the Chinese Patent Office on June 18, 2015, and entitled "COMMUNICATIONS DEVICE", which is incorporated herein by reference in its entirety.

### TECHNICAL FIELD

The present invention relates to the communications device field, and in particular, to a communications device.

### BACKGROUND

As a lightest structural material, a magnesium alloy has advantages such as light weight, high specific strength, good electromagnetic shielding and shock absorption performance, and a good forming property, and is widely applied to aeronautics and astronautics, automobiles, and consumer electronics, and an application field of the magnesium alloy is being rapidly expanded. In recent years, communications devices are becoming more light-weighted. A conventional aluminum alloy gradually fails to meet an application requirement due to relatively high density. The magnesium alloy rapidly enters an application field of the communications device due to a remarkable advantage, that is, light weight of the magnesium alloy.

However, due to power consumption and a working environment of the communications device and a structural feature of the device, a material applied to the communications device needs to comprehensively have high heat conductivity, high corrosion resistance, high structural mechanics performance, and high processing and forming performance. The heat conductivity, mechanics performance, and forming performance usually affect each other, and are even mutually contradictory. Therefore, wide application of the magnesium alloy on the communications device is restricted. Therefore, a communications device that uses a magnesium alloy material needs to be proposed, to meet comprehensive requirements of a lightweight communications device on aspects such as heat dissipation performance, corrosion resistance, mechanics performance, and forming and processing performance.

### SUMMARY

Embodiments of the present invention provide a communications device, which can meet requirements of a lightweight communications device on heat dissipation performance, corrosion resistance, mechanics performance, and forming and processing performance.

According to a first aspect, a communications device is provided, where the communications device includes an electronic part and a magnesium alloy housing, the electronic part is disposed in a closed cavity formed by the magnesium alloy housing and is in contact with a cavity wall of the cavity, the magnesium alloy housing is configured to isolate the electronic part from the outside and is configured to dissipate heat generated by the electronic part, and constituents in a magnesium alloy material used in the magnesium alloy housing are configured according to the following mass percentages:
aluminum: less than 10%;
rare-earth element: 1% to 10%
manganese: less than 1%;
zinc: less than 1%;
zirconium: less than 1%; and
calcium: less than 3%; and
the rest is magnesium and an unavoidable impurity.

With reference to the first aspect, in a first possible implementation of the first aspect, the magnesium takes up 75% to 97%.

With reference to the first aspect, in a second possible implementation of the first aspect, the constituents in the magnesium alloy material are configured according to the following mass percentages:
aluminum: 3% to 6%;
rare-earth element: 3% to 6%
manganese: 0.1% to 0.5%;
zinc: less than 0.5%;
zirconium: less than 0.5%; and
calcium: less than 0.5%; and
the rest is magnesium and the unavoidable impurity.

With reference to the first aspect, the first possible implementation of the first aspect, or the second possible implementation of the first aspect, in a third implementation of the first aspect, the magnesium takes up 86% to 93%.

With reference to any one of the first aspect, or the first possible implementation of the first aspect to the third possible implementation of the first aspect, in a fourth implementation of the first aspect, a heat dissipation fin is disposed on an outer surface of the magnesium alloy housing.

With reference to any one of the first aspect, or the first possible implementation of the first aspect to the fourth possible implementation of the first aspect, in a fifth implementation of the first aspect, the magnesium alloy housing is formed by means of die casting.

With reference to any one of the first aspect, or the first possible implementation of the first aspect to the fifth possible implementation of the first aspect, in a sixth implementation of the first aspect, the communications device is a radio frequency module, the electronic part includes a printed circuit board PCB and a power module, the PCB is configured to process a received signal, and the power module is configured to supply power to a component disposed on the PCB.

With reference to the sixth possible implementation of the first aspect, in a seventh possible implementation of the first aspect, the radio frequency module is fixed on an antenna enclosure frame, and is configured to process a signal received from the antenna enclosure frame.

Based on the foregoing technical solution, the communications device in the embodiments of the present invention uses the magnesium alloy housing manufactured by using the magnesium alloy material with a specific constituent content. The magnesium alloy material has high heat dissipation performance, high corrosion resistance, high structural mechanics performance, and high forming and processing performance. Therefore, the communications device in the embodiments of the present invention can meet requirements of a lightweight communications device on heat dissipation, corrosion resistance, mechanics performance, and forming and processing performance.

### BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic cross-sectional diagram of a communications device according to an embodiment of the present invention; and
FIG. 2 is a schematic diagram of a housing of a communications device according to an embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention.

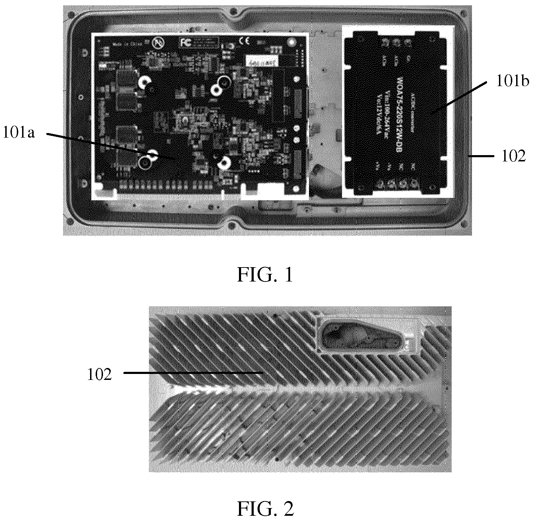

An embodiment of the present invention provides a communications device 100. As shown in FIG. 1, the communications device 100 includes an electronic part 101 and a magnesium alloy housing 102. The electronic part 101 is disposed in a closed cavity formed by the magnesium alloy housing 102 and is in contact with a cavity wall of the cavity. The magnesium alloy housing 102 is configured to isolate the electronic part 101 from the outside and is configured to dissipate heat generated by the electronic part 101.

The electronic part 101 may be in direct contact with the cavity wall of the cavity, or may be in indirect contact with the cavity wall of the cavity. This embodiment of the present invention sets no limitation thereto.

It should be understood that the electronic part 101 shown in FIG. 1 includes two portions: 101a and 101b. However, the present invention is not limited thereto. The electronic part 101 may be a whole, or may be an electronic part including an electronic element including multiple portions.

Constituents in a magnesium alloy material used in the magnesium alloy housing 102 are configured according to the following mass percentages:
aluminum: less than 10%;
rare-earth element: 1% to 10%
manganese: less than 1%;
zinc: less than 1%;
zirconium: less than 1%; and
calcium: less than 3%; and
the rest is magnesium and an unavoidable impurity.

For example, the unavoidable impurity in the magnesium alloy material may be one of silicon, iron, copper, nickel, or the like, or a mixture thereof.

The rare-earth element is one of lanthanum, cerium, praseodymium, or neodymium, or a mixture of several rare-earth elements.

The constituents may be adjusted within the foregoing range as required. This embodiment of the present invention sets no limitation thereto. For example, the aluminum may take up 2% to 3%, 3% to 4%, 4% to 5%, 5% to 6%, or the like, and the rare earth may take up 2% to 3%, 3% to 4%, 4% to 5%, 7% to 8%, or the like.

According to tests and research, a lightweight communications device requires the magnesium alloy material used in the magnesium alloy housing to have the following characteristics: heat conductivity ≥ 75 W/MK, Brinell hardness ≥ 40, tensile strength ≥ 120 Mpa, yield strength ≥ 90 Mpa, and an elongation rate ≥ 0.5%. Under a same condition, a neutral salt spray corrosion rate of the magnesium alloy material is less than or equal to a neutral salt spray corrosion rate of a magnesium alloy AZ91D. Under a same technical state, a spiral or zigzag flow length of the magnesium alloy material is greater than 50% of a spiral or zigzag flow length of the magnesium alloy AZ91D.

According to tests, the magnesium alloy material used in the magnesium alloy housing in this embodiment of the present invention can meet the foregoing comprehensive requirements of the lightweight communications device on heat conductivity, corrosion resistance, structural mechanics performance, and high processing and forming performance.

The magnesium alloy material in this embodiment of the present invention has high conductivity. Therefore, the magnesium alloy housing 102 can conduct, in time, the heat generated by the electronic part 101 to a surface on which the magnesium alloy housing 102 is in contact with an external environment, and dissipate the heat. Further, a heat-conducting medium (for example, heat-conducting silicone grease) may be filled in a gap between the electronic part 101 and the cavity of the magnesium alloy housing 102, to increase an area on which the electronic part 101 is in contact with the cavity of the magnesium alloy housing 102, so that the heat generated by the electronic part 101 can be rapidly conducted to the magnesium alloy housing 102.

In addition, the magnesium alloy housing 102 in this embodiment of the present invention also has excellent corrosion resistance performance. The electronic part 101 inside the housing is isolated from the environment, to prevent the electronic part 101 from being corroded and being invalid due to direct contact with the environment, so that erosion caused by the environment can be resisted, and the electronic part 101 is better protected.

Moreover, the magnesium alloy material in this embodiment of the present invention has high tensile strength, high yield strength, and a high elongation rate. Therefore, the magnesium alloy housing 102 in this embodiment of the present invention has high connection reliability and high structural reliability, and can be reliably connected to another communications device or part and provide highly reliable protection for the internal electronic element 101.

The magnesium alloy material in this embodiment of the present invention has high heat dissipation performance, high corrosion resistance, high structural mechanics performance, and high forming and processing performance. Therefore, the magnesium alloy housing 102 manufactured by using the magnesium alloy material can have efficient heat dissipation, high corrosion resistance, and high structural strength, and heat of the lightweight communications device can be dissipated and the lightweight communications device can be used outdoors.

The communications device in this embodiment of the present invention uses the magnesium alloy housing manufactured by using the magnesium alloy material with a specific constituent content. The magnesium alloy material has high heat dissipation performance, high corrosion resistance, high structural mechanics performance, and high forming and processing performance. Therefore, the communications device in this embodiment of the present invention can meet the requirements of the lightweight communications device on heat dissipation, corrosion resistance, mechanics performance, and forming and processing performance.

Optionally, the magnesium takes up 75% to 97%.

Optionally, the constituents in the magnesium alloy material are configured according to the following mass percentages:
aluminum: 3% to 6%;
rare earth: 3% to 6%;
manganese: 0.1% to 0.5%;
zinc: less than 0.5%;
zirconium: less than 0.5%; and
calcium: less than 0.5%; and
the rest is magnesium and the unavoidable impurity.

Optionally, the magnesium takes up 86% to 93%.

Table 1 shows typical values and representations of performance of several magnesium alloy materials commonly used in an existing communications device. It can be learned with reference to Table 1 that the currently used magnesium alloy materials cannot meet all the comprehensive requirements of the lightweight communications device on high heat conductivity, high corrosion resistance, high structural mechanics performance, and high processing and forming performance. However, the magnesium alloy material of the communications device in this embodiment of the present invention can meet all the comprehensive requirements of the lightweight communications device on high heat conductivity, high corrosion resistance, high structural mechanics performance, and high processing and forming performance.

In Table 1, a value range of corrosion resistance and a forming capability is 1 to 5. Larger values respectively indicate worse corrosion resistance and a worse forming capability.

The magnesium alloy housing in this embodiment of the present invention has high heat conductivity, can meet a requirement of the communications device on high heat dissipation performance, has high connection reliability such as thread reliability and high structural reliability, and further has excellent corrosion resistance. Therefore, the communications device in this embodiment of the present invention can be directly exposed in an outdoor environment.

**Table 1**

| | AZ91D | AZ81D | AM60B | AM50A | AM20 | AE42 | AS418 |
|---|---|---|---|---|---|---|---|
| Tensile strength mpa | 230 | 220 | 220 | 220 | 220 | 185 | 225 |
| Yield strength mpa | 160 | 150 | 130 | 120 | 105 | 140 | 140 |
| Elongation rate | 3% | 3% | 6-8% | 6-10% | 8-12% | 8-10% | 6% |
| Brinell hardness | 75 | 72 | 62 | 57 | 47 | 57 | 75 |
| Heat conductivity w/mk | 72 | 51 | 62 | 62 | 60 | 68 | 68 |
| Corrosion resistance (neutral salt spray) | 1 | 1 | 1 | 1 | 2 | 1 | 2 |
| Forming capability | 1 | 1 | 2 | 2 | 4 | 2 | 2 |
| Existing problem when being applied to a communications device | Low heat conducti -vity | Low heat conducti -vity | Poor forming capability and low heat conductivity | Poor forming capability, low heat conductivity, and poor corrosion resistance | Poor forming capability | Poor forming capability | Poor forming capability |

Optionally, a heat dissipation fin is disposed on an outer surface of the magnesium alloy housing 102, as shown in FIG. 2. In this way, a heat dissipation area can be increased, to improve heat dissipation efficiency.

Optionally, height of the heat dissipation fin ≥ 30 mm, and thickness of the heat dissipation fin ≤ 1.8 mm.

Optionally, height of the heat dissipation fin ≥ 50 mm, and thickness of the heat dissipation fin ≤ 1.2 mm.

The magnesium alloy material in this embodiment of the present invention has an excellent forming capability. Therefore, a complex thin-wall structure can be formed, that is, a heat dissipation fin with high and thin teeth can be manufactured. Therefore, the heat dissipation area is greatly increased, to further improve the heat dissipation efficiency.

Optionally, the magnesium alloy housing 102 is formed by means of die casting.

Alternatively, the magnesium alloy housing 102 may be formed by using another technology. This embodiment of the present invention sets no limitation thereto.

Optionally, the communications device may be a radio frequency module. Correspondingly, 101a shown in FIG. 1 is a printed circuit board (Printed Circuit Board, PCB for short) 101a, and 101b is a power module. The PCB 101a is configured to process a signal, and the power module 101b is configured to supply power to a component disposed on the PCB 101a.

Optionally, the radio frequency module in this embodiment is fixed on an antenna enclosure frame, and is configured to process a signal collected by the antenna enclosure frame.

It should be understood that the communications device in this embodiment of the present invention may be another device. The present invention sets no limitation thereto.

The communications device in this embodiment of the present invention has an efficient heat dissipation capability as well as high corrosion resistance performance, and is applicable to an outdoor application scenario.

It should be understood that the magnesium alloy housing 102 in this embodiment of the present invention may form a complete closed cavity; or may form a half cavity, and a complete closed cavity is formed by fixing the magnesium alloy housing 102 to another device or part.

When the magnesium alloy housing and the electronic part (such as the PCB and the power module) fixed in the cavity of the magnesium alloy housing are used as a whole and connected to another housing or another non-housing part by using a screw or the like, to form a communications device with a closed cavity, a groove may be provided at a conjunction of two portions of the cavity. An organic sealing ring having a sealing effect is embedded in the groove, to ultimately form a closed cavity with a waterproof effect. The magnesium alloy housing provides a function of conducting heat that is generated when the electronic part works in the closed cavity, and dissipating the heat to the external environment. In addition, the magnesium alloy housing protects a functional component such as the PCB and the power module inside the magnesium alloy housing.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A communications device, wherein the communications device comprises an electronic part and a magnesium alloy housing, the electronic part is disposed in a closed cavity formed by the magnesium alloy housing and is in contact with a cavity wall of the cavity, the magnesium alloy housing is configured to isolate the electronic part from the outside and is configured to dissipate heat generated by the electronic part, and constituents in a magnesium alloy material used in the magnesium alloy housing are configured according to the following mass percentages:
aluminum: less than 10%;
rare-earth element: 1% to 10%
manganese: less than 1%;
zinc: less than 1%;
zirconium: less than 1%; and
calcium: less than 3%; and
the rest is magnesium and an unavoidable impurity.

2. The communications device according to claim 1, wherein the magnesium takes up 75% to 97%.

3. The communications device according to claim 1, wherein the constituents in the magnesium alloy material are configured according to the following mass percentages:
aluminum: 3% to 6%;
rare-earth element: 3% to 6%
manganese: 0.1% to 0.5%;
zinc: less than 0.5%;
zirconium: less than 0.5%; and
calcium: less than 0.5%; and
the rest is magnesium and the unavoidable impurity.

4. The communications device according to any one of claims 1 to 3, wherein the magnesium takes up 86% to 93%.

5. The communications device according to any one of claims 1 to 4, wherein a heat dissipation fin is disposed on an outer surface of the magnesium alloy housing.

6. The communications device according to any one of claims 1 to 5, wherein the magnesium alloy housing is formed by means of die casting.

7. The communications device according to any one of claims 1 to 6, wherein the communications device is a radio frequency module, the electronic part comprises a printed circuit board PCB and a power module, the PCB is configured to process a received signal, and the power module is configured to supply power to a component disposed on the PCB.

8. The communications device according to claim 7, wherein the radio frequency module is fixed on an antenna enclosure frame, and is configured to process a signal received from the antenna enclosure frame.
